# EUROPEAN PATENT APPLICATION

(11) **EP 4 187 623 A1**
(43) Date of publication of application: **31.05.2023**
(21) Application number: 20946378.5
(22) Date of filing: 21.07.2020
(51) Int. Cl.: H01L 33/42, H01L 33/58, H01L 33/22

(54) **SEMICONDUCTOR LIGHT-EMITTING DEVICE AND DISPLAY DEVICE USING SEMICONDUCTOR LIGHT-EMITTING DEVICE**

(71) Applicant: LG ELECTRONICS INC., Yeongdeungpo-Gu Seoul 07336 (KR)
(72) Inventor: KIM, Jungsub, Seoul 06772 (KR); KIM, Myoungsoo, Seoul 06772 (KR); KWON, Taein, Seoul 06772 (KR); LIM, Chunghyun, Seoul 06772 (KR)
(74) Representative: Vossius & Partner Patentanwälte Rechtsanwälte mbB
(86) International application number: PCT/KR2020/009585
(87) International publication number: WO 2022/019346

(57) **Abstract**

A semiconductor light-emitting device according to the present invention comprises: a first conductive type electrode; a first conductive type semiconductor layer having the first conductive type electrode formed on one surface thereof and an undoped semiconductor layer formed on the other surface thereof; an active layer formed on one surface of the first conductive type semiconductor layer; a second conductive type semiconductor layer formed on the active layer; and a second conductive type electrode formed on the second conductive type semiconductor layer, wherein the undoped semiconductor layer includes a light transmissive layer made of an electrically conductive material and formed at the surface thereof other than the surface where the first conductive type semiconductor layer is formed.

## Description

### Technical Field

The present disclosure relates to a semiconductor light-emitting device, particularly, a semiconductor light-emitting device having a size of several to several tens of µm and a display device using the same.

### Background Art

In recent years, in the field of display technology, liquid-crystal displays (LCDs), organic light-emitting diodes (OLED) displays, semiconductor light-emitting displays, etc. have been competing to realize large-area displays.

Semiconductor light-emitting devices (elements, diodes) (hereinafter, microLEDs) with a cross-sectional area of 100 *µ*m or less, when used in displays, may offer very high efficiency because the displays do not need a polarizer to absorb light. However, in order to implement large-scale displays, several millions of semiconductor light-emitting devices (elements) are required, which makes it difficult to transfer the semiconductor light-emitting devices, compared to other technologies.

In recent years, microLEDs can be transferred by pick & place, laser lift-off or self-assembly. Among others, the self-assembly approach is a method that allows semiconductor light-emitting devices to find their positions on their own in a fluid, which is most advantageous in realizing large-screen display devices.

Self-assembly methods may include a method of directly assembling semiconductor light-emitting devices on a final substrate to be used in a product, and a method of assembling semiconductor light-emitting devices on an assembly substrate and transferring the semiconductor light-emitting devices to a final substrate through an additional transfer process. The direct transfer method is efficient in terms of process, and the hybrid-transfer method is advantageous in terms of additionally using a structure for self-assembly without limitation. Therefore, the two methods are selectively used.

### Disclosure of Invention

### Technical Problem

One aspect of the present disclosure is to provide a semiconductor light-emitting device (element) having a structure capable of improving a self-assembly yield, and a display device having the semiconductor light-emitting devices.

Another aspect of the present disclosure is to provide a display device with improved light extraction efficiency.

### Solution to Problem

A semiconductor light-emitting device according to the present disclosure may include a first conductive electrode, a first conductive semiconductor layer having one surface with the first conductive electrode, and another surface with an undoped semiconductor layer, an active layer disposed on the one surface of the first conductive semiconductor layer, a second conductive semiconductor layer disposed on the active layer, and a second conductive electrode disposed on the second conductive semiconductor layer. The semiconductor light-emitting device may include a light-transmitting layer disposed on a surface where the first conductive semiconductor layer is disposed with respect to the undoped semiconductor layer, and formed of a material having electrical conductivity.

According to the present disclosure, the light-transmitting layer may have at least one surface with surface roughness.

According to the present disclosure, the light-transmitting layer may be a transparent electrode layer.

According to the present disclosure, the light-transmitting layer may have a thickness of 30 nm to 500 nm.

According to the present disclosure, the light-transmitting layer may be a semiconductor layer doped with an n-type dopant.

According to the present disclosure, the light-transmitting layer may have electrical conductivity that is equal to or higher than that of the first conductive semiconductor layer.

According to the present disclosure, the light-transmitting layer may have a thickness of 50 nm to 200 nm.

A display device according to the present disclosure may include a base, semiconductor light-emitting devices disposed on the base and each including conductive electrodes, wiring electrodes disposed on the base and electrically connected to the conductive electrodes of the semiconductor light-emitting devices. Each of the semiconductor light-emitting devices may include a first conductive electrode, a first conductive semiconductor layer having one surface with the first conductive electrode, and another surface with an undoped semiconductor layer, an active layer disposed on the one surface of the first conductive semiconductor layer, a second conductive semiconductor layer disposed on the active layer, and a second conductive electrode disposed on the second conductive semiconductor layer. The semiconductor light-emitting device may include a light-transmitting layer disposed on a surface where the first conductive semiconductor layer is disposed with respect to the undoped semiconductor layer, and formed of a material having electrical conductivity.

According to the present disclosure, the semiconductor light-emitting device may be disposed such that the light-transmitting layer faces the base.

According to the present disclosure, the base portion may further include a reflective layer disposed at least at a position corresponding to a position where the semiconductor light-emitting device is disposed.

According to the present disclosure, the display device may further include a connection electrode extending from the first conductive electrode and the second conductive electrode of the semiconductor light-emitting device to the wire electrode, and the connection electrode may be made of a transparent material.

According to the present disclosure, the base may be made of a light-transmitting material.

According to the present disclosure, the light-transmitting layer may have at least one surface with surface roughness.

According to the present disclosure, the light-transmitting layer may be a transparent electrode layer.

According to the present disclosure, the light-transmitting layer may be a semiconductor layer doped with an n-type dopant.

### Advantageous Effects of Invention

Dielectrophoretic force of a semiconductor light-emitting device according to the present disclosure can be increased during self-assembly, and thus an assembly rate of the semiconductor light-emitting device can be improved. In addition, according to the present disclosure, since the dielectrophoretic force of the semiconductor light-emitting device is increased by a light-transmitting layer, light extraction efficiency of a display device using the semiconductor light-emitting device can be improved.

### Brief Description of Drawings

FIG. 1 is a conceptual view illustrating one embodiment of a display device using semiconductor light-emitting devices.
FIG. 2 is a partial enlarged view of a portion A in the display device of FIG. 1.
FIG. 3 is an enlarged view of the semiconductor light-emitting device of FIG. 2.
FIG. 4 is a view illustrating another embodiment of the semiconductor light-emitting device of FIG. 2.
FIGS. 5A to 5E are conceptual diagrams illustrating a new process for manufacturing a semiconductor light-emitting device.
FIG. 6 is a conceptual diagram illustrating one embodiment of a device for self-assembling semiconductor light-emitting devices according to the present disclosure.
FIG. 7 is a block diagram of the self-assembly device of FIG. 6.
FIGS. 8A to 8E are conceptual views illustrating a process for self-assembling semiconductor light-emitting devices using the self-assembly device of FIG. 6.
FIG. 9 is a view illustrating one embodiment of a semiconductor light-emitting device that is used in the self-assembly process of FIGS. 8A to 8E.
FIGS. 10A to 10C are conceptual views illustrating another transfer process of semiconductor light-emitting devices after a self-assembly process according to the present disclosure.
FIGS. 11 to 13 are flowcharts illustrating a method for manufacturing a display device including semiconductor light-emitting devices that emit red (R), green (G), and blue (B) light.
FIG. 14 is a view illustrating another embodiment of the related art semiconductor light-emitting device that is used in the self-assembly process of FIGS. 8A to 8E.
FIG. 15 is a view illustrating one embodiment of a semiconductor light-emitting device according to the present disclosure used in a self-assembly process.
FIG. 16 is a view schematically illustrating a process of manufacturing the semiconductor light-emitting device of FIG. 15.
FIG. 17 is a view illustrating another embodiment of a semiconductor light-emitting device according to the present disclosure used in a self-assembly process.
FIG. 18 is a view schematically illustrating a process of manufacturing the semiconductor light-emitting device of FIG. 17.
FIG. 19 is a graph showing a comparison of dielectrophoretic forces between a semiconductor light-emitting device according to the present disclosure and the related art semiconductor light-emitting device.
FIG. 20 is a view illustrating the related art display device using the semiconductor light-emitting device of FIG. 14.
FIG. 21 is a view illustrating one embodiment of a display device according to the present disclosure using the semiconductor light-emitting device according to FIG. 15 or 17.
FIG. 22 is a view illustrating another embodiment of a display device according to the present disclosure using the semiconductor light-emitting device according to FIG. 15 or 17.

### Mode for the Invention

Description will now be given in detail according to exemplary implementations disclosed herein, with reference to the accompanying drawings. For the sake of brief description with reference to the drawings, the same or equivalent components may be provided with the same or similar reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In describing the present disclosure, if a detailed explanation for a related known function or construction is considered to unnecessarily divert the gist of the present disclosure, such explanation has been omitted but would be understood by those skilled in the art. The accompanying drawings are used to help easily understand the technical idea of the present disclosure and it should be understood that the idea of the present disclosure is not limited by the accompanying drawings. Furthermore, it will be understood that when an element such as a layer, region or substrate is referred to as being "on" another element, it can be directly on the another element or an intermediate element may also be interposed therebetween.

A display device disclosed herein may include a portable (mobile) phone, a smart phone, a laptop computer, a digital broadcast terminal, a personal digital assistant (PDA), a portable multimedia player (PMP), a navigation, a slate PC, a tablet PC, an ultrabook, a digital TV, a desktop computer, and the like. However, the configuration according to the implementation described herein can be applied as long as it can include a display even in a new product form to be developed later.

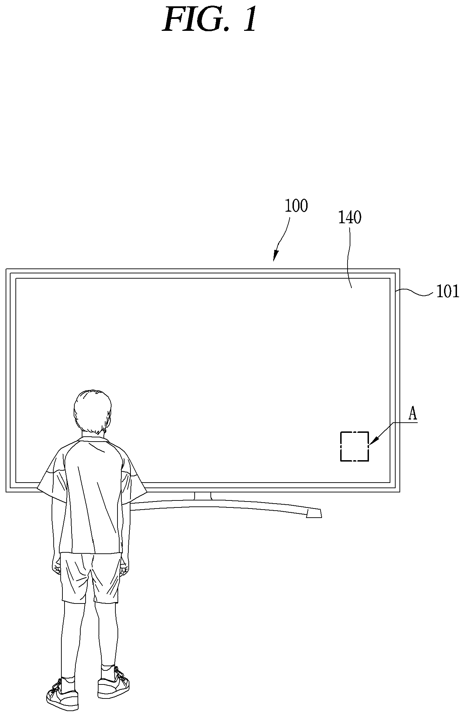

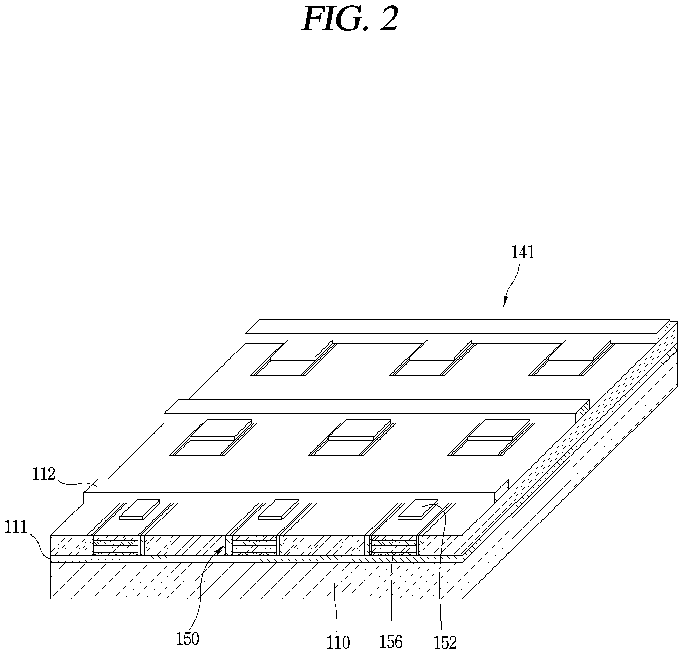

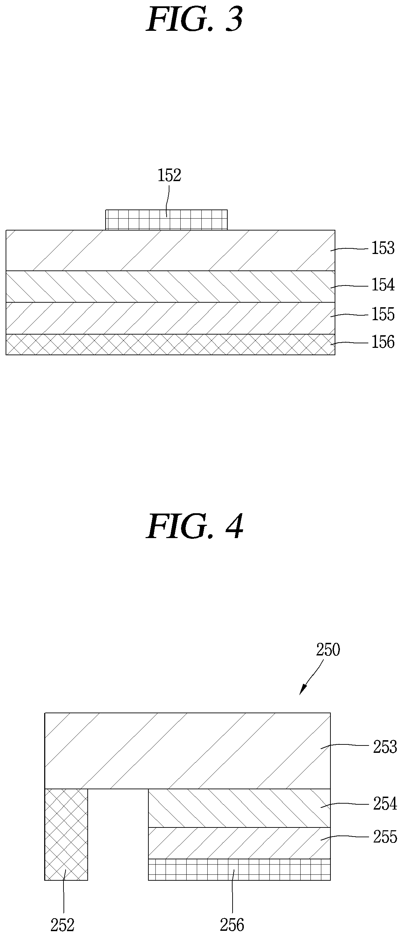

FIG. 1 is a conceptual view illustrating one embodiment of a display device using semiconductor light-emitting devices, FIG. 2 is a partial enlarged view of a portion A in the display device of FIG. 1, FIG. 3 is an enlarged view of the semiconductor light-emitting device of FIG. 2, and FIG. 4 is a view illustrating another embodiment of the semiconductor light-emitting device of FIG. 2.

As illustrated, information processed by a controller of a display device 100 may be output on a display module 140. A closed loop-shaped case 101 that runs around the rim of the display module 140 may define the bezel of the display device 100.

The display module 140 may include a panel 141 that displays an image, and the panel 141 may include micro-sized semiconductor light-emitting devices (or elements) 150 and a wiring substrate 110 where the semiconductor light-emitting devices 150 are mounted.

The wiring substrate 110 may be provided with wirings, which can be connected to n-type electrodes 152 and p-type electrodes 156 of the semiconductor light-emitting devices 150. As such, the semiconductor light-emitting devices 150 may be provided on the wiring substrate 110 as individual pixels that emit light on their own.

The image displayed on the panel 141 may be visual information, which is rendered by controlling the light emission of unit pixels arranged in a matrix configuration independently through the wirings.

The present disclosure takes microLEDs (light-emitting devices) as an example of the semiconductor light-emitting devices 150 which convert current into light. The microLEDs may be light-emitting devices that are small in size less than 100 *µ*m. The semiconductor light-emitting devices 150 may have light-emitting regions of red, green, and blue, and unit pixels may be produced by combinations of these colors. That is, the unit pixels are the smallest units for producing one color. Each unit pixel may contain at least three microLEDs.

More specifically, referring to FIG. 3, the semiconductor light-emitting device 150 may have a vertical structure.

For example, the semiconductor light-emitting devices 150 may be implemented as high-power light-emitting devices that are composed mostly of gallium nitride (GaN), with some indium (In) and/or aluminum (Al) added to it, and emit light of various colors.

Such a vertical semiconductor light-emitting device may include a p-type electrode 156, a p-type semiconductor layer 155 disposed on the p-type semiconductor layer 156, an active layer 154 disposed on the p-type semiconductor layer 155, an n-type semiconductor layer 153 disposed on the active layer 154, and an n-type electrode 152 disposed on the n-type semiconductor layer 153. In this case, the p-type electrode 156 at the bottom may be electrically connected to a p-electrode 111 of the wiring substrate, and the upper n-type electrode 152 at the top may be electrically connected to an n-electrode 112 above the semiconductor light-emitting device. The electrodes can be disposed in an upward/downward direction in the vertical semiconductor light-emitting device 150, thereby providing a great advantage of reducing a chip size.

In another example, referring to FIG. 4, the semiconductor light-emitting devices may be flip chip-type light-emitting devices.

As an example of such a flip chip-type light-emitting device, the semiconductor light-emitting device 250 may include a p-type electrode 256, a p-type semiconductor layer 255 disposed on the p-type layer 256, an active layer 254 disposed on the p-type semiconductor layer 255, an n-type semiconductor layer 253 disposed on the active layer 254, and an n-type electrode 252 vertically separated from the p-type electrode 256 on the n-type semiconductor layer 253. In this case, both the p-type electrode 256 and the n-type electrode 252 may be electrically connected to a p electrode and an n electrode of the wiring substrate, below the semiconductor light-emitting device.

The vertical semiconductor light-emitting device and a flip-type light-emitting device each may be used as a green semiconductor light-emitting device, blue semiconductor light-emitting device, or red semiconductor light-emitting device. The green semiconductor light-emitting device and the blue semiconductor light-emitting device may be implemented as high-power light-emitting devices that are composed mostly of gallium nitride (GaN), with some indium (In) and/or aluminum (Al) added to it, and emit green and blue light, respectively. As an example, the semiconductor light-emitting devices may be made of gallium nitride thin films which include various layers of n-Gan, p-GaN, AlGaN, InGaN, etc. More specifically, the p-type semiconductor layer may be P-type GaN, and the n-type semiconductor layer may be N-type GaN. However, for the red semiconductor light-emitting device, the p-type semiconductor layer may be P-type GaAs, and the n-type semiconductor layer may be N-type GaAs.

Moreover, the p-type semiconductor layer may be P-type GaN doped with Mg on the p electrode, and the n-type semiconductor layer may be N-type GaN doped with Si on the n electrode. In this case, the above-described semiconductor light-emitting devices may be semiconductor light-emitting devices without the active layer.

In some examples, referring to FIGS. 1 to 4, because of the very small size of the light-emitting devices, self-emissive, high-definition unit pixels may be arranged on the display panel, and therefore the display device can deliver high picture quality.

In the display device using the semiconductor light-emitting devices, semiconductor light-emitting devices may be grown on a wafer, formed through mesa and isolation, and used as individual pixels. The micro-sized semiconductor light-emitting devices 150 should be transferred onto preset positions on a substrate of the display panel. One of the transfer technologies available may be pick and place, but it has a low success rate and requires a lot of time. In another example, a number of diodes may be transferred at a time by using a stamp or roll, which, however, is not suitable for large-screen displays because of limited yields. The present disclosure proposes a new method and device for manufacturing a display device that can solve these problems.

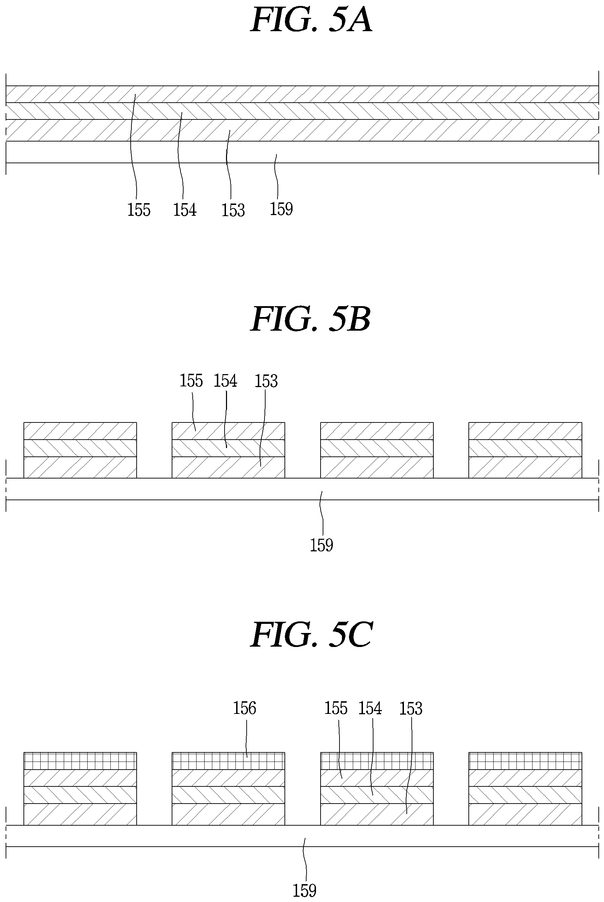

To this end, a new method for manufacturing a display device will be described first below. FIGS. 5A to 5E are conceptual views illustrating a new process for manufacturing the semiconductor light-emitting devices (or elements).

In this specification, a display device using passive matrix (PM) semiconductor light-emitting devices will be illustrated. It should be noted that the illustration given below is also applied to active matrix (AM) semiconductor light-emitting devices. In addition, the self-assembly method described in this specification can be applied to both horizontal semiconductor light-emitting devices and vertical semiconductor light-emitting devices.

First of all, according to the manufacturing method of the display device, a first conductive (type) semiconductor layer 153, an active layer 154, and a second conductive (type) semiconductor layer 155 are grown on a growth substrate 159 (FIG. 5A).

Once the first conductive semiconductor layer 153 is grown, the active layer 154 may be grown on the first conductive semiconductor layer 153 and then the second conductive semiconductor layer 155 may be grown on the active layer 154. By sequentially growing the first conductive semiconductor layer 153, the active layer 154, and the second conductive semiconductor layer 155, the first conductive semiconductor layer 153, the active layer 154, and the second conductive semiconductor layer 155 may form a stack structure as illustrated in FIG. 5A.

In this case, the first conductive semiconductor layer 153 may be a n-type semiconductor layer, and the second conductive semiconductor layer 155 may be a p-type semiconductor layer. However, the present disclosure is not necessarily limited to this, and the first conductive type may be p-type and the second conductive type may be n-type.

Moreover, although this exemplary implementation is illustrated by assuming the presence of the active layer, the active layer may be omitted, if necessary, as stated above. In an example, the p-type semiconductor layer may be P-type GaN doped with Mg, and the n-type semiconductor layer may be N-type GaN doped with Si on the n electrode.

The growth substrate 159 (wafer) may be formed of, but not limited to, light-transmissive material, for example, one of sapphire (Al2O3), GaN, ZnO, and AlO. Also, the growth substrate 159 may be made of a material suitable for growing semiconductor materials, namely, a carrier wafer. The growth substrate 2101 may also be formed of a material having high thermal conductivity. The growth substrate 2101 may use at least one of a SiC substrate having higher thermal conductivity than the sapphire (Al2O3) substrate, Si, GaAs, GaP, InP and Ga2O3, in addition to a conductive substrate or an insulating substrate.

Next, a plurality of semiconductor light-emitting devices may be formed by removing at least parts of the first conductive semiconductor layer 153, the active layer 154, and the second conductive semiconductor layer 155 (FIG. 5B).

More specifically, isolation may be performed so that the plurality of light-emitting devices form a light-emitting device array. That is, a plurality of semiconductor light-emitting devices may be formed by vertically etching the first conductive semiconductor layer 153, the active layer 154, and the second conductive semiconductor layer 155.

In the case of horizontal semiconductor light-emitting devices, a mesa process may be performed which exposes the first conductive semiconductor layer 153 to the outside by vertically removing part of the active layer 154 and the second conductive semiconductor layer 155, and then isolation may be performed which forms an array of semiconductor light-emitting devices by etching the first conductive semiconductor layer 153.

Next, a second conductive electrode 156 (or p-type electrode) may be formed on one surface of the second conductive semiconductor layer 155 (FIG. 5C). The second conductive electrode 156 may be formed by a deposition method such as sputtering, but the present disclosure is not necessarily limited to this. In a case where the first conductive semiconductor layer and the second conductive semiconductor layer are an n-type semiconductor layer and a p-type semiconductor layer, respectively, the second conductive electrode 156 may serve as an n-type electrode.

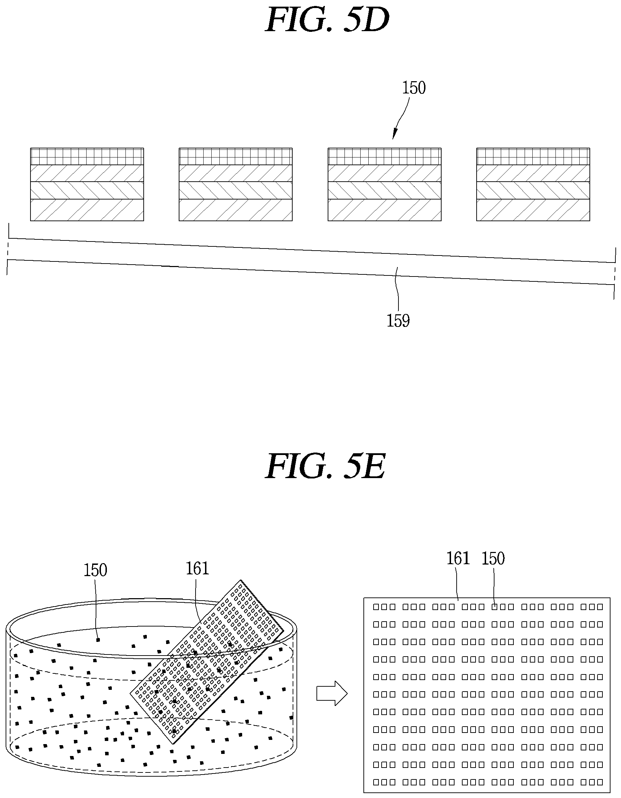

Next, the growth substrate 159 may be removed, thus leaving a plurality of semiconductor light-emitting devices. For example, the growth substrate 159 may be removed using laser lift-off (LLO) or chemical lift-off (CLO) (FIG. 5D).

Afterwards, the step of mounting the semiconductor light-emitting devices 150 on a substrate in a chamber filled with a fluid may be performed (FIG. 5E).

For example, the semiconductor light-emitting devices 150 and the substrate 161 may be put into a chamber filled with a fluid, and the semiconductor light-emitting devices may be self-assembled onto the substrate 161 using fluidity, gravity, surface tension, etc. In this case, the substrate may be an assembly substrate 161.

In another example, a wiring substrate, instead of the assembly substrate 161, may be put into a fluid chamber, and the semiconductor light-emitting devices 150 may be mounted directly onto the wiring substrate. In this case, the substrate may be a wiring substrate. For convenience of explanation, the present disclosure is illustrated with an example in which the semiconductor light-emitting devices 150 are mounted onto the assembly substrate 161.

To facilitate the mounting of the semiconductor light-emitting devices 150 onto the assembly substrate 161, cells (not shown) into which the semiconductor light-emitting devices 150 are fitted may be provided on the assembly substrate 161. Specifically, cells where the semiconductor light-emitting devices 150 are mounted may be disposed on the assembly substrate 161 at positions where the semiconductor light-emitting devices 150 are aligned with wiring electrodes. The semiconductor light-emitting devices 150 may be assembled to the cells as they move within the fluid.

After arraying the semiconductor light-emitting devices 150 on the assembly substrate 161, the semiconductor light-emitting devices 150 may be transferred to the wiring substrate from the assembly substrate 161, thereby enabling a large-area transfer across a large area. Thus, the assembly substrate 161 may be referred to as a temporary substrate.

Meanwhile, the above-explained self-assembly method requires a higher transfer yield so that it can be applied to the manufacture of large-screen displays. The present disclosure proposes a method and device that minimizes the effects of gravity or friction and avoids non-specific binding, in order to increase the transfer yield.

In this case, in the display device according to the present disclosure, a magnetic material may be placed on the semiconductor light-emitting devices so that the semiconductor light-emitting devices are moved by magnetic force, and the semiconductor light-emitting devices may be mounted at preset positions by an electric field in the process of being moved. This transfer method and device will be described in more detail below with reference to the accompanying drawings.

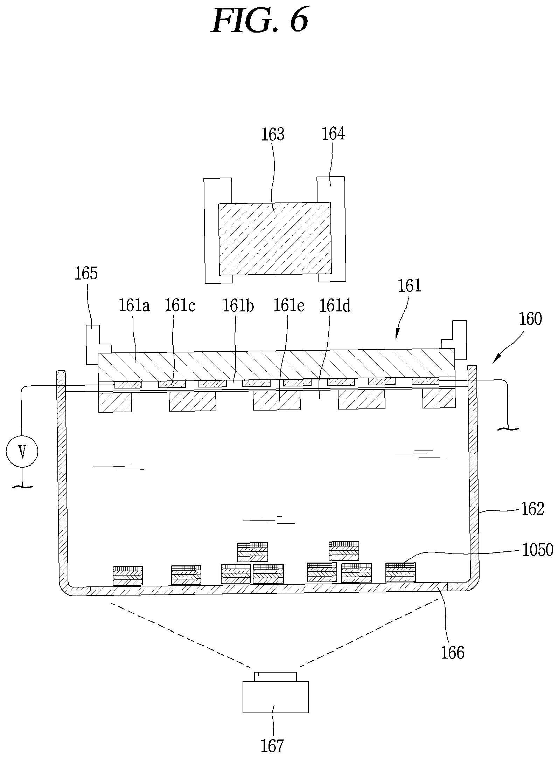

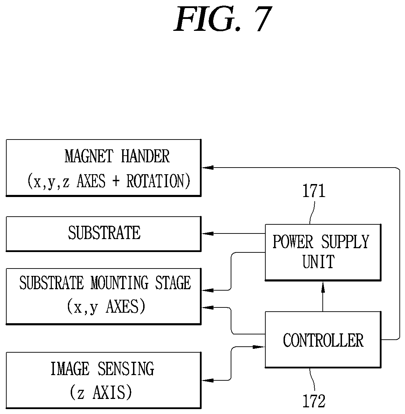

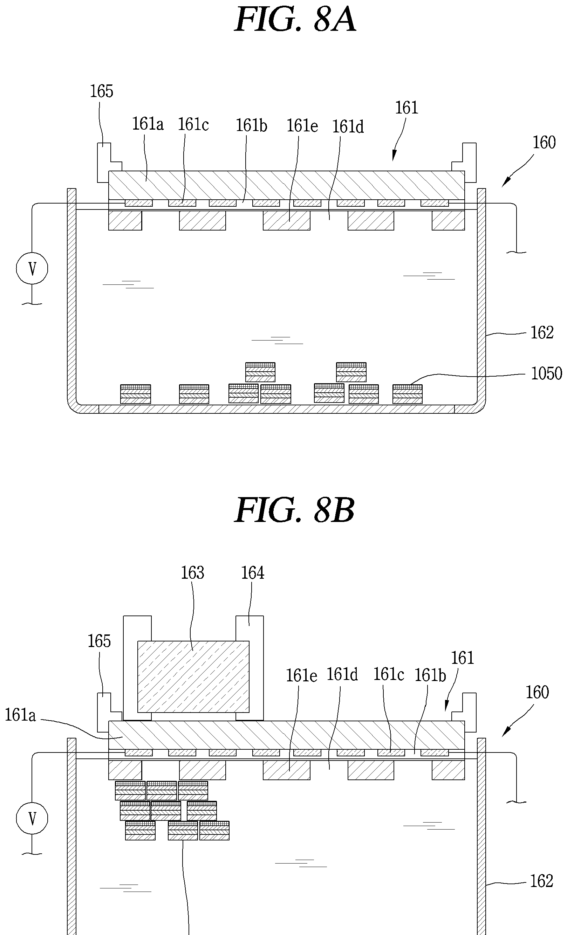

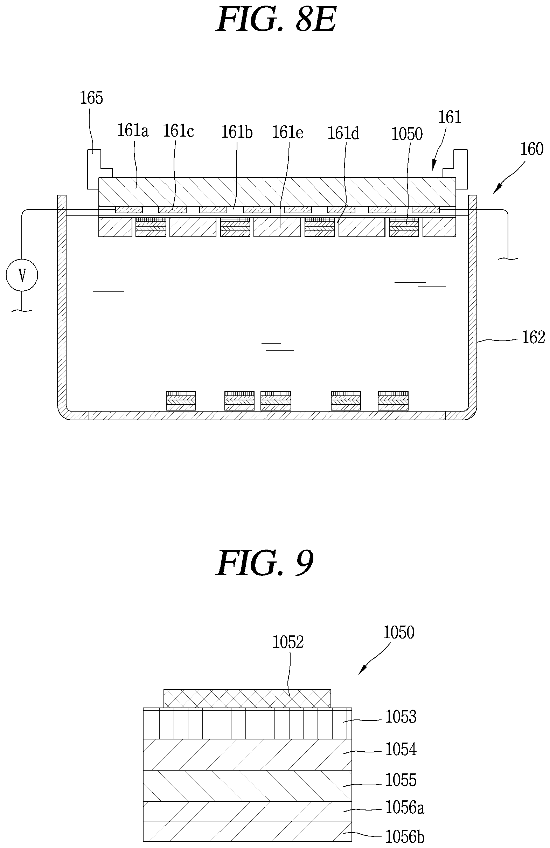

FIG. 6 is a conceptual diagram illustrating an example of a device for self-assembling semiconductor light-emitting devices and FIG. 7 is a block diagram of the self-assembly device of FIG. 6. FIGS. 8A to 8E are conceptual view illustrating a process for self-assembling semiconductor light-emitting devices using the self-assembly device of FIG. 6 and FIG. 9 is a conceptual view illustrating the semiconductor light-emitting device of FIGS. 8A to 8E.

Referring to FIGS. 6 and 7, the self-assembly device 160 may include a fluid chamber 162, a magnet 163, and a position controller 164.

The fluid chamber 162 may define a space for receiving a plurality of semiconductor light-emitting devices. The space may be filled with a fluid, and the fluid may be an assembly solution, which includes water or the like. Thus, the fluid chamber 162 may be a water tank and configured as an open-type. However, the present disclosure is not limited to this, and the fluid chamber 162 may be a closed-type chamber in which the space is in a closed state.

A substrate 161 may be placed in the fluid chamber 162 so that an assembly surface where the semiconductor light-emitting devices 150 are assembled faces downwards. For example, the substrate 161 may be fed to an assembly site by a feed unit (transfer unit), and the transfer unit may include a stage 165 where the substrate is mounted. The position of the stage 165 may be adjusted by the controller, whereby the substrate 161 can be fed to the assembly site.

In this instance, the assembly surface of the substrate 161 at the assembly site may face the bottom of the fluid chamber 162. As illustrated in the drawings, the assembly surface of the substrate 161 may be placed to be soaked with the fluid in the fluid chamber 162. Thus, the semiconductor light-emitting devices 150 in the fluid may be moved to the assembly surface.

The substrate 161 may be an assembly substrate where an electric field can be formed, and may include a base portion 161a, a dielectric layer 161b, and a plurality of electrodes 161c.

The base portion 161a may be made of an insulating material, and the plurality of electrodes 161c may be thin-film or thick-film bi-planar electrodes that are patterned on one surface of the base portion 161a. The electrodes 161c may be formed of a stack of Ti/Cu/Ti, Ag paste, ITO, etc.

The dielectric layer 161b may be made of an inorganic material such as SiO2, SiNx, SiON, Al2O3, TiO2, HfO2, etc. Alternatively, the dielectric layer 161b may be an organic insulator and configured as a single layer or multi-layers. The thickness of the dielectric layer 161b may range from several tens of nm to several *µ*m.

Further, the substrate 161 according to the present disclosure includes a plurality of cells 161d that are separated by barrier walls. The cells 161d may be sequentially arranged in one direction and made of a polymer material. Furthermore, the barrier walls 161e defining the cells 161d may be made to be shared with neighboring cells 161d. The barrier walls 161e may protrude from the base portion 161a, and the cells 161d may be sequentially arranged in one direction by the barrier walls 161e. More specifically, the cells 161d may be sequentially arranged in column and row directions and have a matrix configuration.

As illustrated in the drawings, the cells 161d may have recesses for receiving the semiconductor light-emitting devices 150, and the recesses may be spaces defined by the barrier walls 161e. The recesses may have a shape identical or similar to the shape of the semiconductor light-emitting devices. For example, if the semiconductor light-emitting devices are rectangular, the recesses may be rectangular too. Moreover, although not shown, the recesses formed in the cells may be circular if the semiconductor light-emitting devices are circular. Moreover, each of the cells is configured to accommodate a single semiconductor light-emitting device. In other words, a single semiconductor light-emitting device is accommodated in a single cell.

Meanwhile, the plurality of electrodes 161c may have a plurality of electrode lines that are placed on bottoms of the cells 161d, and the plurality of electrode lines may extend to neighboring cells.

The plurality of electrodes 161c may be placed beneath the cells 161d, and different polarities may be applied to create an electric field within the cells 161d. To form an electric field, the dielectric layer 161b may form the bottom of the cells 161d while covering the electrodes 161c. With this structure, when different polarities are applied to a pair of electrodes 161c beneath each cell 161d, an electric field may be formed and the semiconductor light-emitting devices can be inserted into the cells 161d by the electric field.

The electrodes of the substrate 161 at the assembly site may be electrically connected to a power supply 171. The power supply 171 may perform the function of generating the electric field by applying power to the electrodes.

As shown in the drawings, the self-assembly device may have the magnet 163 for applying magnetic force to the semiconductor light-emitting devices. The magnet 163 may be disposed at a distance from the fluid chamber 162 to apply magnetic force to the semiconductor light-emitting devices 150. The magnet 163 may be disposed to face an opposite side of the assembly surface of the substrate 161, and the position of the magnet 163 may be controlled by the position controller 164 connected to the magnet 163.

The semiconductor light-emitting devices 1050 may have a magnetic material so that they can be moved within the fluid by a magnetic field.

Referring to FIG. 9, a semiconductor light-emitting device having a magnetic material may include a first conductive electrode 1052, a second conductive electrode 1056, a first conductive semiconductor layer 1053 on which the first conductive electrode 1052 is disposed, a second conductive semiconductor layer 1055 which overlaps the first conductive semiconductor layer 1052 and on which the second conductive electrode 1056 is disposed, and an active layer 1054 disposed between the first and second conductive semiconductor layers 1053 and 1055.

Here, the first conductive may refer to p-type, and the second conductive type may refer to n-type, or vice versa. As stated previously, the semiconductor light-emitting device may be formed without the active layer.

Meanwhile, the first conductive electrode 1052 may be formed after the semiconductor light-emitting device is assembled onto the wiring substrate by the self-assembling of the semiconductor light-emitting device. Further, the second conductive electrode 1056 may include a magnetic material. The magnetic material may refer a magnetic metal. The magnetic material may be Ni, SmCo, etc. In another example, the magnetic material may include at least one of Gd-based, La-based, and Mn-based materials.

The magnetic material may be provided in the form of particles on the second conductive electrode 1056. Alternatively, one layer of a conductive electrode including a magnetic material may be made of the magnetic material. As an example, the second conductive electrode 1056 of the semiconductor light-emitting device 1050 may include a first layer 1056a and a second layer 1056b, as illustrated in FIG. 9. Here, the first layer 1056a may include a magnetic material, and the second layer 1056b may include a metal material other than the magnetic material.

As illustrated in the drawing, in this example, the first layer 1056a including the magnetic material may be disposed in contact with the second conductive semiconductor layer 1055. In this case, the first layer 1056a may be disposed between the second layer 1056b and the second conductive semiconductor layer 1055. The second layer 1056b may be a contact metal that is connected to the second electrode on the wiring substrate. However, the present disclosure is not necessarily limited to this, and the magnetic material may be disposed on one surface of the first conductive semiconductor layer.

Still referring to FIGS. 6 and 7, more specifically, on top of the fluid chamber of the self-assembly device, a magnet handler capable of automatically or manually moving the magnet 163 on the x, y, and z axes or a motor capable of rotating the magnet 163 may be provided. The magnet handler and motor may constitute the position controller 164. As such, the magnet 163 may rotate in a horizontal, clockwise, or counterclockwise direction with respect to the substrate 161.

Meanwhile, the fluid chamber 162 may be provided with a light-transmissive bottom plate 166, and the semiconductor light-emitting devices may be disposed between the bottom plate 166 and the substrate 161. An image sensor 167 may be disposed to face the bottom plate 166 so as to monitor the inside of the fluid chamber 162 through the bottom plate 166. The image sensor 167 may be controlled by a controller 172, and may include an inverted-type lens, CCD, etc. so as to observe the assembly surface of the substrate 161.

The self-assembly device may be configured to use a magnetic field and an electric field in combination. With this, the semiconductor light-emitting devices can be mounted at preset positions on the substrate by the electric field while being moved by changes in the position of the magnet. Hereinafter, the assembly process using the self-assembly device will be described in more detail.

First of all, a plurality of semiconductor light-emitting devices 1050 having a magnetic material may be formed through the process explained with reference to FIGS. 5A to 5C. In this case, the magnetic material may be deposited onto the semiconductor light-emitting devices in the process of forming the second conductive electrode of FIG. 5C.

Next, the substrate 161 may be fed to an assembly site, and the semiconductor light-emitting devices 1050 may be put into the fluid chamber 162 (FIG. 8A).

As described above, the assembly site on the substrate 161 may be a position at which the substrate 161 is placed in the fluid chamber 162 in such a way that an assembly surface where the semiconductor light-emitting devices 150 are assembled faces downwards.

In this case, some of the semiconductor light-emitting devices 1050 may sink to the bottom of the fluid chamber 162 and some of them may float in the fluid. When the fluid chamber 162 is provided with the light-transmissive bottom plate 166, some of the semiconductor light-emitting devices 1050 may sink to the bottom plate 166.

Next, magnetic force may be applied to the semiconductor light-emitting devices 1050 so that the semiconductor light-emitting devices 1050 in the fluid chamber 162 come up to the surface (FIG. 8B).

When the magnet 163 of the self-assembly device moves to the opposite side of the assembly surface of the substrate 161 from its original position, the semiconductor light-emitting devices 1050 may float in the fluid towards the substrate 161. The original position may refer to s position at which the magnet 163 is outside the fluid chamber 162. As another example, the magnet 163 may be configured as an electromagnet. In this case, an initial magnetic force may be generated by supplying electricity to the electromagnet.

Meanwhile, in this implementation, the spacing between the assembly surface of the substrate 161 and the semiconductor light-emitting devices 1050 may be controlled by adjusting strength of the magnetic force. For example, the spacing may be controlled by using weight, buoyancy, and magnetic force of the semiconductor light-emitting devices 1050. The spacing may be several millimeters to several tens of micrometers from the outermost part of the substrate 161.

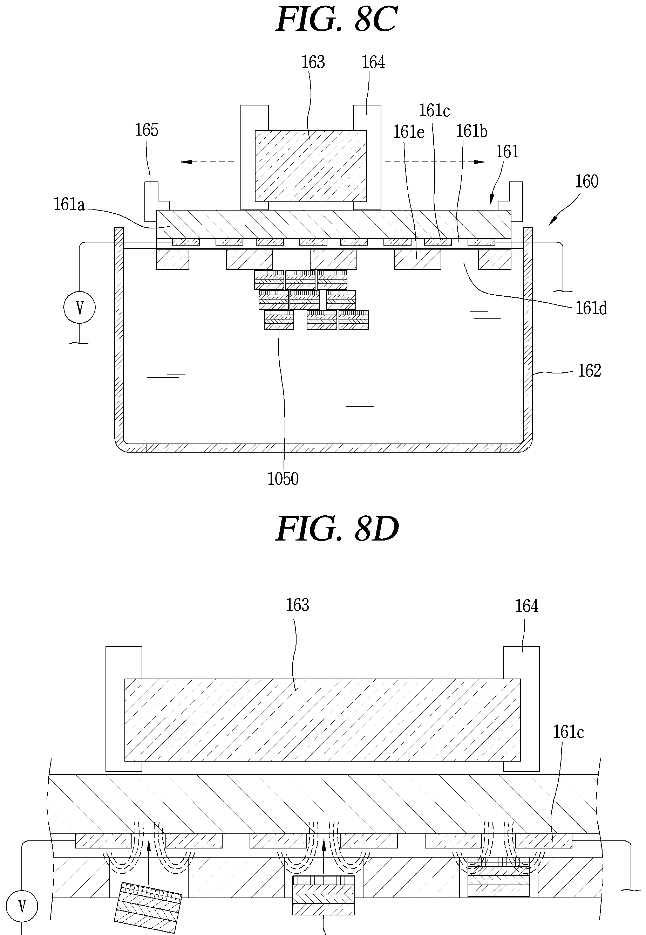

Next, magnetic force may be applied to the semiconductor light-emitting devices 1050 so that the semiconductor light-emitting devices 1050 can move in one direction within the fluid chamber 162. For example, the magnet 163 may move in a horizontal direction to the substrate, a clockwise direction, or a counterclockwise direction (FIG. 8C). In this case, the semiconductor light-emitting devices 1050 may be moved horizontally with respect to the substrate 161 by the magnetic force, with being spaced apart from the substrate 161.

Next, the semiconductor light-emitting devices 1050 may be guided to preset positions on the substrate 161 by applying an electric field so that the semiconductor light-emitting devices 1050 are mounted at the preset positions during their movement (FIG. 8C). For example, the semiconductor light-emitting devices 1050 may be moved vertically with respect to the substrate 161 by the electric field while being moved horizontally with respect to the substrate 161, thereby being placed at the preset positions of the substrate 161.

More specifically, an electric field may be generated by supplying power to bi-planar electrodes on the substrate 161, and the semiconductor light-emitting electrodes 1050 may be guided to be assembled only at the preset positions by the electric field. That is, the semiconductor light-emitting devices 1050 may be self-assembled at the assembly site on the substrate 161 by a selectively generated electric field. To this end, the substrate 161 may be provided with cells into which the semiconductor light-emitting devices 1050 are fitted.

Afterwards, unloading of the substrate 161 may be performed, thereby completing the assembly process. In a case where the substrate 161 is an assembly substrate, the assembled semiconductor light-emitting devices may be transferred onto a wiring substrate to carry out a subsequent process for realizing the display device, as described previously.

Meanwhile, after the semiconductor light-emitting devices 1050 are guided to the preset positions, the magnet 163 may be moved away from the substrate 161 such that the semiconductor light-emitting devices 1050 remaining in the fluid chamber 162 fall to the bottom of the fluid chamber 162 (FIG. 8D). In another example, when power supply is stopped in a case where the magnet 163 is an electromagnet, the semiconductor light-emitting devices 1050 remaining in the fluid chamber 162 may fall to the bottom of the fluid chamber 162.

Thereafter, the semiconductor light-emitting devices 1050 on the bottom of the fluid chamber 162 may be collected, and the collected semiconductor light-emitting devices 1050 may be re-used.

In the above-explained self-assembly device and method, parts at far distances may be concentrated near a preset assembly site by using a magnetic field in order to increase assembly yields in a fluidic assembly, and guided to be selectively assembled only at the assembly site by applying an electric field to the assembly site. In this case, the assembly substrate may be positioned on top of a water tank, with its assembly surface facing downward, thereby minimizing the effect of gravity from the weights of the parts and avoiding non-specific binding and eliminating defects. That is, the assembly substrate may be placed on the top to increase transfer yields, thus minimizing the effect of gravity or friction and avoiding non-specific binding.

As seen from above, with the configuration, a large number of semiconductor light-emitting devices can be assembled at a time in a display device where individual pixels are made up of semiconductor light-emitting devices.

As such, a large number of semiconductor light-emitting devices can be pixelated on a small-sized wafer and then transferred onto a large-area substrate. This enables the manufacture of a large-area display device at a low cost.

Meanwhile, the present disclosure provides a structure and method of an assembly substrate for increasing the yields of the self-assembly process and the process yields after the self-assembly. The present disclosure is limited to a case where the substrate 161 is used as an assembly substrate. That is, the assemble substrate to be described later is not used as the wiring substrate of the display device. Hereinafter, the substrate 161 is referred to as an assembly substrate 161.

The present disclosure improves the process yields in two respects. First, the present disclosure prevents semiconductor light-emitting diodes from being mounted on undesired positions due to an electric field strongly formed at the undesired positions. Second, the present disclosure prevents the semiconductor light-emitting devices from remaining on the assemble substrate when transferring the semiconductor light-emitting devices mounted on the assemble substrate to another substrate.

The above-mentioned objectives are not individually achieved by different components. The above-described two objectives can be achieved by organic coupling of components to be described later and the assembly substrate 161 described above.

Before describing the present disclosure in detail, a post-process for manufacturing a display device after self-assembling will be described.

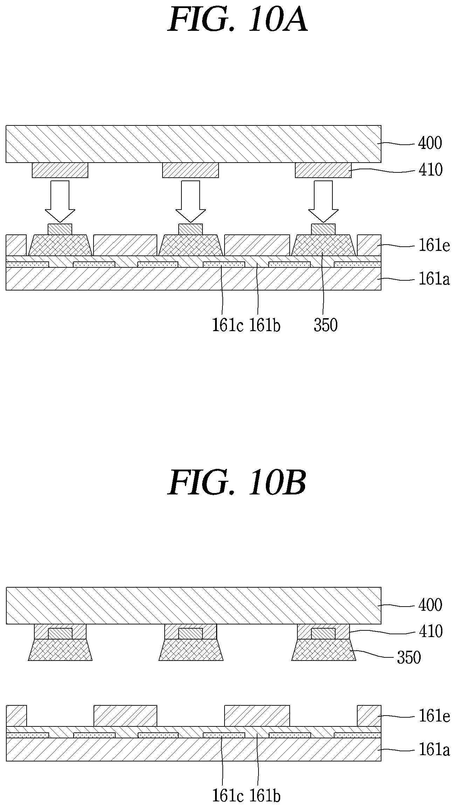

FIGS. 10A to 10C are conceptual diagrams illustrating a state in which the semiconductor light-emitting devices are transferred after a self-assembling process according to the present disclosure.

When the self-assembly process described with reference to FIGS. 8A to 8E is completed, the semiconductor light-emitting devices are mounted on the assembly substrate 161 at preset positions. The semiconductor light-emitting devices mounted on the assembly substrate 161 are transferred at least once to another substrate. This specification illustrates one embodiment in which the semiconductor light-emitting devices mounted on the assembly substrate 161 are transferred twice, but the present disclosure is not limited thereto. The semiconductor light-emitting devices mounted on the assembly substrate 161 may be transferred to another substrate once or three times or more.

On the other hand, immediately after the self-assembly process is completed, the assembly surface of the assembly substrate 161 faces downwards (or the gravity direction). For the process after the self-assembly, the assembly substrate 161 may be turned by 180 degrees with the semiconductor light-emitting devices mounted thereon. In this process, there is a risk that the semiconductor light-emitting devices are likely to be separated from the assembly substrate 161. Therefore, a voltage must be applied to the plurality of electrodes 161c (hereinafter, referred to as assembly electrodes) while the assembly substrate 161 is turned. An electric field formed between the assembly electrodes prevents the semiconductor light-emitting devices from being separated from the assembly substrate 161 while the assembly substrate 161 is turned.

When the assembly substrate 161 is turned by 180 degrees after the self-assembly process, a shape as shown in FIG. 10A is made. Specifically, as shown in FIG. 10A, the assembly surface of the assembly substrate 161 is in a state of facing upwards (or the opposite direction to gravity). In this state, a transfer substrate 400 is aligned above the assembly substrate 161.

The transfer substrate 400 is a substrate for separating the semiconductor light-emitting devices placed on the assembly substrate 161 and transferring them to the wiring substrate. The transfer substrate 400 may be formed of PDMS (polydimethylsiloxane). Accordingly, the transfer substrate 400 may be referred to as a PDMS substrate.

The transfer substrate 400 is aligned above the assembly substrate 161 and then pressed onto the assembly substrate 161. When the transfer substrate 400 is fed above the assembly substrate 161, the semiconductor light-emitting devices 350 mounted on the assembly substrate 161 are transferred to the transfer substrate 400 by the adhesive force of the transfer substrate 400.

To this end, surface energy between the semiconductor light-emitting devices 350 and the transfer substrate 400 should be higher than surface energy between the semiconductor light-emitting devices 350 and the dielectric layer 161b. When there is a greater difference between the surface energy between the semiconductor light-emitting devices 350 and the transfer substrate 400 and the surface energy between the semiconductor light-emitting devices 350 and the dielectric layer 161b, the probability that the semiconductor light-emitting devices 350 are separated from the assembly substrate 161 is more increased. Therefore, it is preferable that the difference between the two surface energies is great.

Meanwhile, the transfer substrate 40 may include a plurality of protrusions 410 that allow pressure applied by the transfer substrate 400 to be concentrated on the semiconductor light-emitting devices 350 when pressing the transfer substrate 400 onto the assembly substrate 161. The protrusions 410 may be formed at the same interval as the semiconductor light-emitting devices mounted on the assembly substrate 161. When the transfer substrate 400 is pressed onto the assembly substrate 161 after the protrusions 410 are aligned to overlap the semiconductor light-emitting devices 350, the pressure applied by the transfer substrate 400 can be concentrated only on the semiconductor light-emitting devices 350. Thus, the present disclosure increases the probability that the semiconductor light-emitting devices are separated from the assembly substrate 161.

Meanwhile, in a state where the semiconductor light-emitting devices are mounted on the assembly substrate 161, parts of the semiconductor light-emitting devices are preferably exposed to the outside of recesses. If the semiconductor light-emitting devices 350 are not exposed to the outside of the recesses, the pressure applied by the transfer substrate 400 is not concentrated on the semiconductor light-emitting devices 350, which may lower the probability that the semiconductor light-emitting devices 350 are separated from the assembly substrate 161.

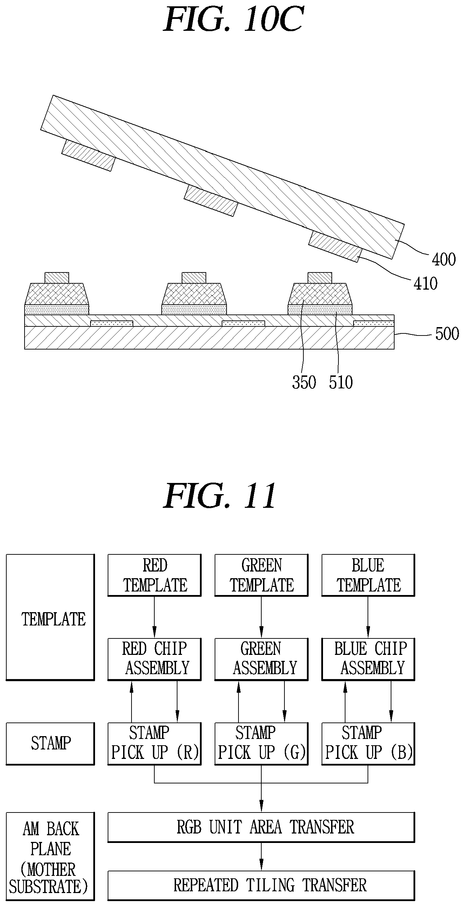

Lastly, referring to FIG. 10C, the step of pressing the transfer substrate 400 onto the wiring substrate 500 and transferring the semiconductor light-emitting devices 350 from the transfer substrate 400 to the wiring substrate 500 is carried out. At this time, the wiring substrate 500 may be provided with protrusions 510. The transfer substrate 400 and the wiring substrate 500 are aligned so that the semiconductor light-emitting devices 350 disposed on the transfer substrate 400 overlap the protrusions 510. Thereafter, when the transfer substrate 400 is pressed onto the wiring substrate 500, the probability that the semiconductor light-emitting devices 350 are separated from the transfer substrate 400 may increase due to the protrusions 510.

On the other hand, in order for the semiconductor light-emitting devices 350 disposed on the transfer substrate 400 to be transferred to the wiring substrate 500, surface energy between the semiconductor light-emitting devices 350 and the wiring substrate 500 should be higher than surface energy between the semiconductor light-emitting devices 350 and the transfer substrate 400. When there is a greater difference between the surface energy between the semiconductor light-emitting devices 350 and the wiring substrate 500 and the surface energy between the semiconductor light-emitting devices 350 and the transfer substrate 400, the probability that the semiconductor light-emitting devices 350 are separated from the transfer substrate 400 is more increased. Therefore, it is preferable that the difference between the two surface energies is great.

After all the semiconductor light-emitting devices 350 disposed on the transfer substrate 400 are transferred onto the wiring substrate 500, the step of establishing electrical connection between the semiconductor light-emitting devices 350 and wiring electrodes provided on the wiring substrate may be performed. The structure of the wiring electrodes and the method of establishing the electrical connection may vary depending on the type of the semiconductor light-emitting devices 350.

Although not shown, an anisotropic conductive film may be disposed on the wiring substrate 500. In this case, the electrical connection can be established between the semiconductor light-emitting devices 350 and the wiring electrodes formed on the wiring substrate 500, simply by pressing the transfer substrate 400 onto the wiring substrate 500.

On the other hand, when manufacturing a display device including semiconductor light-emitting devices emitting light of different colors, the method described in FIGS. 10A to 10C can be implemented in various ways. Hereinafter, a method for manufacturing a display device including semiconductor light-emitting devices that emit red (R), green (G), and blue (B) light will be described.

FIGS. 11 to 13 are flowcharts illustrating a method for manufacturing a display device including semiconductor light-emitting devices that emit red (R), green (G), and blue (B) light.

Semiconductor light-emitting devices emitting light of different colors may be individually assembled to different assembly substrates. Specifically, the assembly substrate 161 may include a first assembly substrate on which semiconductor light-emitting devices emitting light of a first color are mounted, a second assembly substrate on which semiconductor light-emitting devices emitting light of a second color different from the first color are mounted, and a third assembly substrate on which semiconductor light-emitting devices emitting light of a third color different from the first color and the second color are mounted. Different kinds of semiconductor light-emitting devices are assembled to assembly substrates, respectively, according to the method described in FIGS. 8A to 8E. For example, semiconductor light-emitting devices emitting red (R), green (G), and blue (B) light may be assembled to the first to third assemble substrates, respectively.

Referring to FIG. 11, a RED chip, a GREEN chip, and a BLUE chip may be assembled respectively to first to third assembly substrates RED TEMPLATE, GREEN TEMPLATE, and BLUE TEMPLATE. In this state, the RED chip, GREEN chip and BLUE chip may be transferred to the wiring substrate by different transfer substrates, respectively.

Specifically, the step of transferring the semiconductor light-emitting devices, which are mounted on the assembly substrate, to the wiring substrate may include pressing a first transfer substrate (stamp R) onto the first assembly substrate RED TEMPLATE to transfer the semiconductor light-emitting devices (RED chip) emitting the light of first color from the first assembly substrate RED TEMPLATE to the first transfer substrate (stamp R), pressing a second transfer substrate (stamp G) onto the second assembly substrate GREEN TEMPLATE to transfer semiconductor light-emitting devices (GREEN chip) emitting the light of second color from the second assembly substrate GREEN TEMPLATE to the second transfer substrate (stamp G), and pressing a third transfer substrate (stamp B) onto the third assembly substrate BLUE TEMPLATE to transfer semiconductor light-emitting devices (BLUE chip) emitting the light of third color from the third assembly substrate BLUE TEMPLATE to the third transfer substrate (stamp B).

Thereafter, the step of pressing the respective first to third transfer substrates onto the wiring substrate to transfer the semiconductor light-emitting devices emitting the light of first to third colors from the first to third transfer substrates to the wiring substrate, respectively.

According to the manufacturing method according to FIG. 11, three types of assembly substrates and three types of transfer substrates are required to manufacture a display device including a RED chip, a GREEN chip, and a BLUE chip.

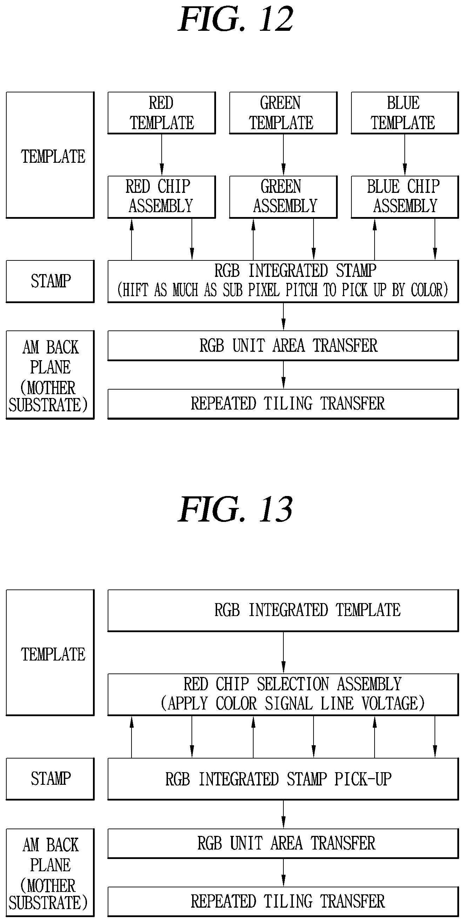

On the contrary, referring to FIG. 12, the RED chip, the GREEN chip, and the BLUE chip may be assembled to the first to third assembly substrates RED TEMPLATE, GREEN TEMPLATE, and BLUE TEMPLATE, respectively. In this state, the RED chip, GREEN chip and BLUE chip may be transferred to the wiring substrate by the same transfer substrate.

Specifically, the step of transferring the semiconductor light-emitting devices, which are mounted on the assembly substrate, to the wiring substrate may include pressing a transfer substrate (RGB integrated stamp) onto the first assembly substrate RED TEMPLATE to transfer the semiconductor light-emitting devices (RED chip) emitting the light of first color from the first assembly substrate RED TEMPLATE to the transfer substrate (RGB integrated stamp), pressing the transfer substrate (RGB integrated stamp) onto the second assembly substrate GREEN TEMPLATE to transfer semiconductor light-emitting devices (GREEN chip) emitting the light of second color from the second assembly substrate GREEN TEMPLATE to the transfer substrate (RGB integrated stamp), and pressing the transfer substrate (RGB integrated stamp) onto the third assembly substrate BLUE TEMPLATE to transfer semiconductor light-emitting devices (BLUE chip) emitting the light of third color from the third assembly substrate BLUE TEMPLATE to the transfer substrate (RGB integrated stamp).

In this case, the alignment positions between each of the first to third assembly substrates and the transfer substrate may be different from each other. For example, when the alignment between the assembly substrates and the transfer substrate is completed, the relative position of the transfer substrate with respect to the first assembly substrate and the relative position of the transfer substrate with respect to the second assembly substrate may be different from each other. The transfer substrate may be shifted in its alignment position by a pitch of a sub pixel every time the type of the assembly substrate is changed. In this way, when the transfer substrate is sequentially pressed onto the first to third assembly substrates, all the three kinds of chips can be transferred to the transfer substrate.

Afterwards, similar to FIG. 11, the step of pressing the transfer substrate onto the wiring substrate to transfer the semiconductor light-emitting devices emitting the light of first to third colors from the transfer substrate to the wiring substrate is performed.

According to the manufacturing method illustrated in FIG. 12, three types of assembly substrates and one type of transfer substrate are required to manufacture a display device including an RED chip, a GREEN chip, and a BLUE chip.

Unlike FIGS. 11 and 12, according to FIG. 13, a RED chip, a GREEN chip, and a BLUE chip may be assembled onto one assembly substrate (RGB integrated TEMPLATE). In this state, each of the RED chip, GREEN chip and BLUE chip can be transferred to the wiring substrate by the same transfer substrate (RGB integrated stamp).

According to the manufacturing method illustrated in FIG. 13, one type of assembly substrate and one type of transfer substrate are required to manufacture a display device including an RED chip, a GREEN chip, and a BLUE chip.

As described above, when manufacturing a display device including semiconductor light-emitting devices emitting light of different colors, the manufacturing method may be implemented in various ways.

Meanwhile, according to the self-assembly process illustrated in FIGS. 8A to 8E, the semiconductor light-emitting device is seated on the assembly substrate by dielectrophoretic force. At this time, in order to improve the assembly force of the semiconductor light-emitting device, a surface of the semiconductor light-emitting device to be seated on the assembly substrate must have high electrical conductivity.

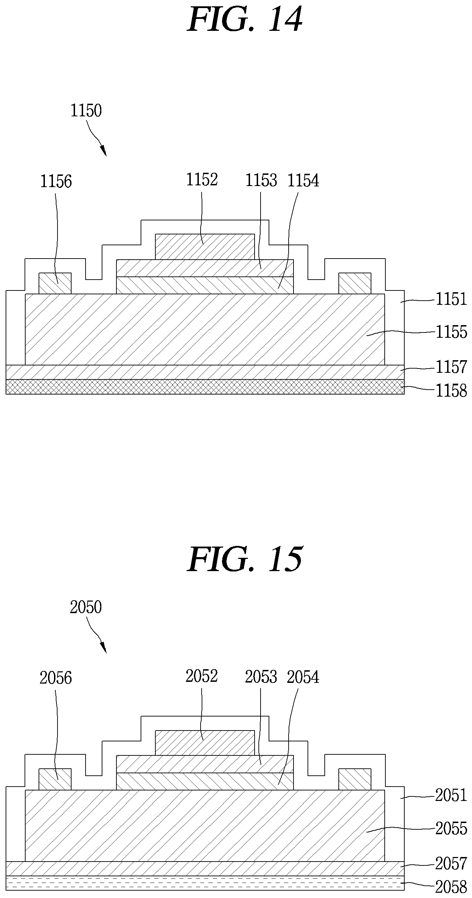

FIG. 14 is a view illustrating another embodiment of the related art semiconductor light-emitting device that is used in the self-assembly process of FIGS. 8A to 8E.

FIG. 14 illustrates a semiconductor light-emitting device (element) 1150 that has improved electrical conductivity of a surface seated on an assembled substrate and is used in a self-assembly process.

In a self-assembly process, semiconductor light-emitting devices having a symmetrical structure such as a circular or elliptical shape are used. Hereinafter, semiconductor light-emitting devices used in the self-assembly process to be described below may have a circular or elliptical shape. In addition, the semiconductor light-emitting devices may include a conductive electrode that contains a magnetic material, for example, Ni.

Referring to FIG. 14, the semiconductor light-emitting device 1150 includes a first conductive electrode 1156, a first conductive semiconductor layer 1155 on which the first conductive electrode 1156 is disposed, an active layer 1154 disposed on the first conductive semiconductor layer 1155, a second conductive semiconductor layer 1153 disposed on the active layer 1154, and a second conductive electrode 1152 disposed on the second conductive semiconductor layer 1153, and has a structure in which a passivation layer 1151 covers a surface thereof.

According to FIG. 14, the semiconductor light emitting device 1150 may further include a conductive layer 1158 on a surface to be seated on the assembly substrate to improve electrical conductivity of the surface. The conductive layer 1158 may be formed on an opposite side of the first and second conductive electrodes 1156 and 1152 with respect to the first conductive semiconductor layer 1155. The conductive layer 1158 may be a metal layer formed by depositing metals such as Ti, In, Sn, Au, Cr, or Mo. Alternatively, after depositing the metal, an oxide film may be further formed on the surface by treatment with plasma and O². In this case, the conductive layer 1158 may be configured as a multi-layer of a metal layer and a metal oxide layer. Meanwhile, an undoped semiconductor layer (or buffer layer) 1157 may be disposed between the first conductive semiconductor layer 1155 and the conductive layer 1158. The conductive layer 1158 may be disposed on the undoped semiconductor layer 1157 and electrically insulated from an epitaxial layer.

In the semiconductor light-emitting device 1150 with the structure illustrated in FIG. 14, as described above, the electrical conductivity of the surface to be seated on the assembly substrate can be improved and thus an assembly rate can be enhanced. However, the semiconductor light-emitting device 1150 has reflectance of 90 % or less in a wavelength region of generated light (visible light region), which causes a problem that light extraction efficiency is lowered. In order to solve this problem, when the conductive layer 1158 is formed of Ag, Al, etc. having high reflectance of 90% or more, the conductive layer 1158 may have a risk of corrosion by a solvent that is used to disperse the semiconductor light-emitting device in a fluid, and may be easily peeled off from the semiconductor light-emitting device 1150 due to a weak adhesion force with the undoped semiconductor layer 1157.

The present disclosure is to solve the above problems, and proposes a semiconductor light-emitting device (element) having a new structure in which a surface thereof to be seated on an assembly substrate has high electrical conductivity. Hereinafter, the structure of the semiconductor light-emitting device according to the present disclosure will be described with reference to FIGS. 15 to 18.

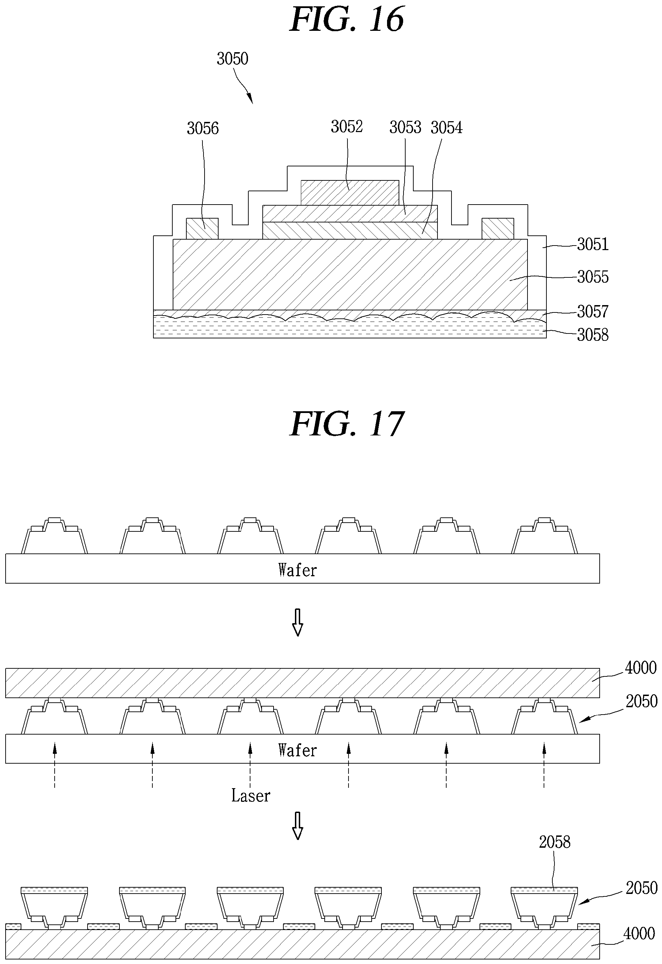

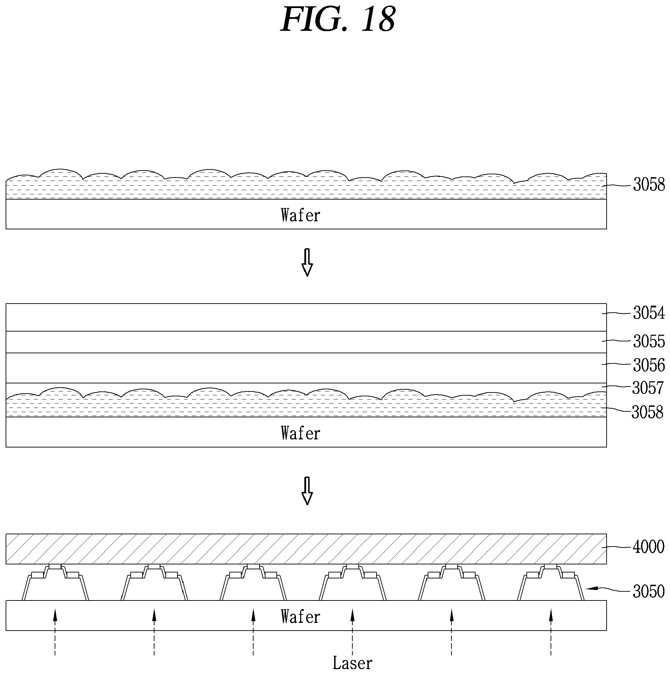

FIG. 15 is a view illustrating one embodiment of a semiconductor light-emitting device according to the present disclosure used in a self-assembly process, and FIG. 16 is a view schematically illustrating a process of manufacturing the semiconductor light-emitting device of FIG. 15. FIG. 17 is a view illustrating another embodiment of a semiconductor light-emitting device according to the present disclosure used in a self-assembly process, and FIG. 18 is a view schematically illustrating a process of manufacturing the semiconductor light-emitting device of FIG. 17.

Referring to FIGS. 15 and 17, the semiconductor light-emitting device 2050, 3050 may include a first conductive electrode 2056, 3056, a first conductive semiconductor layer 2055, 3055 with the first conductive electrode 2056, 3056 formed thereon, an active layer 2054, 3054 disposed on the first conductive semiconductor layer 2055, 3055, a second conductive semiconductor layer 2053, 3053 disposed on the active layer 2054, 3054, and a second conductive electrode 2052, 3052 disposed on the second conductive semiconductor layer 2053, 3053. Specifically, the first conductive electrode 2056, 3056 and the active layer 2054, 3054 are disposed on one surface of the first conductive semiconductor layer 2055, 3055, and an undoped semiconductor layer (or buffer layer) 2057, 3057 may be disposed on the first conductive semiconductor layer 2055, 3055. In addition, a light-transmitting layer 2058, 3058 may be disposed on an opposite side of the first conductive semiconductor layer 2055, 3055 based on the undoped semiconductor layer 2057, 3057. That is, the first conductive semiconductor layer 2055, 3055 may be disposed on one surface of the undoped semiconductor layer 2057, 3057, and the light-transmitting layer 2058, 3058 may be disposed on another surface of the undoped semiconductor layer 2057, 3057. The light-transmitting layer 2058, 3058 may be disposed to improve dielectrophoretic force of the semiconductor light-emitting device 2050, 3050. The light-emitting layer 2058, 3058 may be formed of an electrically conductive material, and disposed on a surface of the semiconductor light-emitting device 2050, 3050 which is seated on an assembly substrate during self-assembly.

In one embodiment, the light-transmitting layer may be a transparent electrode layer 2058. The transparent electrode layer 2058 may be formed of a material having light transmittance of 90% or more in a visible light region and electrical conductivity of 1 S/m or more. To this end, the transparent electrode layer 2058 may be formed of indium tin oxide (ITO), indium gallium zinc oxide (IGZO), indium zinc oxide (IZO), or indium zinc tin oxide (IZTO).

In this embodiment, the transparent electrode layer 2058 may have a thickness of 30 nm to 500 nm. If the transparent electrode layer 2058 is formed thinner than 30 nm, its electrical conductivity is low and does not affect the increase in dielectrophoretic force. On the other hand, if it is formed thicker than 500 nm, light transmittance decreases. In addition, the transparent electrode layer 2058 may be formed in the form of a thin film or may be patterned to include a plurality of protrusions so as to have surface roughness.

Hereinafter, a method for manufacturing a semiconductor light-emitting device 2050 according to one embodiment will be described.

First, a plurality of semiconductor light-emitting devices 2050 may be formed by growing an epitaxial layer on a growth substrate (wafer) and forming an electrode. The wafer may be an insulating substrate made of a light-transmitting material such as a glass substrate or a sapphire substrate. In addition, the wafer may be made of one selected from Si, SiC, GaN, GaP, GaAs, InP, InAs, etc. having excellent thermal conductivity.

The epitaxial layer may be grown on the wafer through metal-organic chemical vapor deposition (MOCVD), molecular beam epitaxy (MBE), chemical vapor deposition (CVD), physical vapor deposition (PVD), hydrogen vapor phase epitaxy (HVPE), and the like. In this embodiment, the first conductive semiconductor layer 2055, the active layer 2054, and the second conductive semiconductor layer 2053 may correspond to the epitaxial layer. The first conductive semiconductor layer 2055, the active layer 2054, and the second conductive semiconductor layer 2053 may be sequentially formed on the wafer. In this case, the first conductive type may be n-type, and the second conductive type may be p-type. For example, a blue semiconductor light-emitting device and a green semiconductor light-emitting device may be formed of various layers which are mainly made of gallium nitride (GaN) and additionally contain indium (In) and/or aluminum (Al). On the other hand, a red semiconductor light-emitting device may be formed of various layers mainly made of gallium arsenide (GaAs). Meanwhile, according to the present disclosure, after the undoped semiconductor layer 2057 is formed on the wafer, the aforementioned epitaxial layer may be formed.

In the state in which the epitaxial layer is formed on the wafer, the plurality of semiconductor light-emitting devices 2050 may be formed through mesa and isolation etching processes. In addition, the first conductive electrode 2056 may be formed on a portion where the first conductive semiconductor layer 2055 is exposed, and the second conductive electrode 2052 may be formed on the second conductive semiconductor layer 2053. At this time, for self-assembly, one of the first conductive electrode 2056 and the second conductive electrode 2052 may be formed to include a magnetic layer. For example, the first conductive electrode 2056 may include a Ni layer having a thickness of 100 nm or more.

Next, after a temporary substrate 4000 is pressed on surfaces of the semiconductor light-emitting devices 2050 formed on the wafer, the semiconductor light-emitting devices 2050 may be separated from the wafer. Specifically, in a state in which the semiconductor light-emitting devices 2050 are transferred to one surface of the temporary substrate 4000, laser beams may be irradiated to portions where the semiconductor light-emitting devices 2050 are formed to separate the semiconductor light-emitting devices 2050 from the wafer.

Next, the transparent electrode layer 2058 may be deposited on the one surface of the temporary substrate 4000 onto which the semiconductor light-emitting devices 2050 are transferred. Accordingly, the transparent electrode layer 2058 may be formed on the undoped semiconductor layer 2057. The transparent electrode layer 2058 may be formed of a material such as ITO, and may be deposited by a thickness of 30 to 500 nm through E-beam, sputtering, plasma-enhanced chemical vapor deposition (PECVD), chemical vapor deposition (CVD), atomic layer deposition (ALD) or the like. The transparent electrode layer 2058 may be formed in the shape of a thin film or may be patterned to include a plurality of protrusions. When the transparent electrode layer 2058 is formed, the semiconductor light-emitting devices 2050 may be separated from the temporary substrate 4000 and dispersed in a fluid.

In another embodiment, the light-transmitting layer may be a semiconductor layer (hereinafter, referred to as a semiconductor layer) 3058 doped with an n-type dopant. The semiconductor layer 3058 may have electrical conductivity that is equal to or higher than that of the first conductive semiconductor layer 3055. Accordingly, the semiconductor layer 3058 may be a semiconductor layer that is doped with a high concentration of an n-type dopant, for example, Si. For example, the semiconductor layer 3058 may have electrical conductivity ranging from 100 S/m to 40000 S/m.

In this embodiment, the semiconductor layer 3058 may have a thickness ranging from 50 nm to 200 nm. If the semiconductor layer 3058 is formed thinner than 50 nm, it does not affect an increase in dielectrophoretic force due to low electrical conductivity. On the other hand, if the semiconductor layer 3058 is formed thicker than 200 nm, it may interfere with the growth of the epitaxial layer later. In addition, the semiconductor layer 3058 may be formed in the shape of a thin film or may be irregularly patterned to have surface roughness.

Hereinafter, a method for manufacturing a semiconductor light-emitting device 3050 according to another embodiment will be described.

According to the embodiment, after forming the semiconductor layer 3058 doped with an n-type dopant (hereinafter, referred to as a semiconductor layer) on the wafer, the undoped semiconductor layer 3057 and the epitaxial layer may be formed on the semiconductor layer 3058. In detail, the semiconductor layer 3058 may be formed to have electrical conductivity that is equal to or higher than that of the first conductive semiconductor layer 3055 of the epitaxial layer, and thus may be a layer doped with an n-type dopant at a high concentration. The semiconductor layer 3058 may be formed to have a thickness of 50 to 200 nm through MOCVD, MBE, CVD, PVD, HVPE, or the like. The semiconductor layer 3058 may be formed in the shape of a thin film or may have surface roughness. In particular, when grown at a low temperature, the semiconductor layer 3058 may have the surface roughness and may also have a discontinuous island structure.

Next, the undoped semiconductor layer 3057 and the epitaxial layer may be sequentially grown on the semiconductor layer 3058, thereby forming the plurality of semiconductor light-emitting devices 3050. The process and subsequent processes will be understood by the foregoing description.

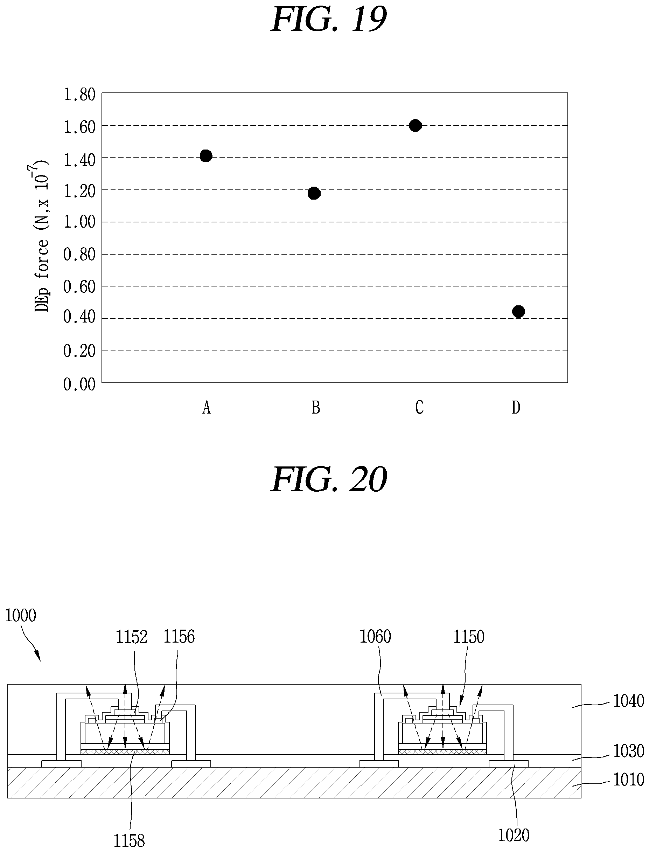

FIG. 19 is a graph showing a comparison of dielectrophoretic forces between a semiconductor light-emitting device according to the present disclosure and the related art semiconductor light-emitting device.

When an AC voltage frequency (10⁴ to 10⁶ Hz) at which self-assembly was performed was applied, dielectrophoretic forces of circular semiconductor light-emitting devices A to D each having a diameter of 50 µm were measured. A is a semiconductor light-emitting device (including a Ti layer) according to FIG. 14, B is a semiconductor light-emitting device (including an ITO layer) according to FIG. 15, C is a semiconductor light-emitting device (including an n-GaN layer) according to FIG. 17, and D is a semiconductor light-emitting device including only an undoped semiconductor layer.

**Table 1]**

| Division | Permittivity | Electrical conductivity (Unit: S/m) | Thickness (unit: nm) |
|---|---|---|---|
| A | 1 | 1.8e⁶ | 30 |
| B | 9.7 | 2e⁴ to 4e⁴ | 30 |
| C | 3.5 | 20 | 30 |
| D | 9.7 | 0.00238 | - |

According to the graph, it can be confirmed that dielectrophoretic force is improved when a layer having electrical conductivity is additionally included, compared to the semiconductor light-emitting device D including only the undoped semiconductor layer. In particular, in the case of the semiconductor light-emitting device C including the n-GaN layer, the dielectrophoretic force was improved by about 2.5 times or more, compared to the semiconductor light-emitting device D including only the undoped semiconductor layer, and was higher than that of the related art semiconductor light-emitting device A including the Ti layer.

That is, the semiconductor light-emitting device according to the present disclosure has an effect of improving a self-assembly rate through a structure having increased dielectrophoretic force.

Hereinafter, a display device using a semiconductor light-emitting device according to the present disclosure will be described. Prior to explaining the display device, problems of the structure of the related art display device will be described with reference to FIG. 20.

FIG. 20 is a view illustrating the related art display device using the semiconductor light-emitting device of FIG. 14.

The display device 1000 may include a base (or substrate) 1010, wiring electrodes 1020 disposed on the base 1010, and semiconductor light-emitting devices 1150 disposed on the base 1010 to be electrically connected to the wiring electrodes 1020.

The base 1010 may be a flexible substrate, and may be formed of an insulating and flexible material to realize flexibility. For example, glass or polyimide (PI) may be included, and polyethylene naphthalate (PEN), polyethylene terephthalate (PET), and the like may also be used. Also, the base 1010 may be formed of any one of a transparent material and a non-transparent material.

The wiring electrodes 1020 and the semiconductor light-emitting devices 1150 may be disposed on the base 1010. In addition, an insulating layer 1030 or the like may be disposed between the wiring electrodes 1020 and the semiconductor light-emitting devices 1150.

The wiring electrodes 1020 and the semiconductor light-emitting devices 1150 that are disposed on the base 1010 may be electrically connected to each other. In detail, the wiring electrodes 1020 may be electrically connected to the first conductive electrode 1156 and the second conductive electrode 1152 of the semiconductor light-emitting device. As an embodiment, a horizontal-type semiconductor light-emitting device, as illustrated in the drawing, may be connected to the wiring electrodes 1020 through connection electrodes 1060 extending from the conductive electrodes of the semiconductor light-emitting device.

In addition, the display device 1000 may include a planarization layer 1040 covering upper surfaces of the semiconductor light-emitting devices 1150 in a state where the semiconductor light-emitting devices 1150 are disposed. For example, the planarization layer 1040 may be formed of a light-transmitting transparent organic film material.

The related art display device 1000 including the semiconductor light-emitting devices according to FIG. 14 may have a top emission structure. Specifically, the display device 1000 may have a structure in which some of light generated by the semiconductor light-emitting device 1150 are directed toward the front surface of the substrate, and light directed toward the rear surface of the substrate is reflected from the conductive layer (or metal layer) 1158 disposed on the rear surface of the semiconductor light-emitting device to be extracted back to the front surface. In this case, the connection electrodes 1060 through which the wiring electrodes 1020 and the conductive electrodes 1156 and 1152 of the semiconductor light-emitting device are connected to each other may be configured as transparent electrodes.

The conductive layer 1158 is a layer that is disposed to improve electrical conductivity of the surface of the semiconductor light-emitting device 1150 which is seated on the assembly substrate through self-assembly, and may include metal layers that are formed by depositing metals such as Ti, In, Sn, Au, Cr, and Mo. However, since the metals forming the conductive layer 1158 have low reflectivity of less than 90% for visible light generated from the semiconductor light-emitting device 1150, significant light loss may occur. In addition, considering light leaking to side surfaces of the semiconductor light-emitting device 1150 in addition to light lost from rear surfaces, there is a problem in that light extraction efficiency of the display device 1000 is generally lowered.

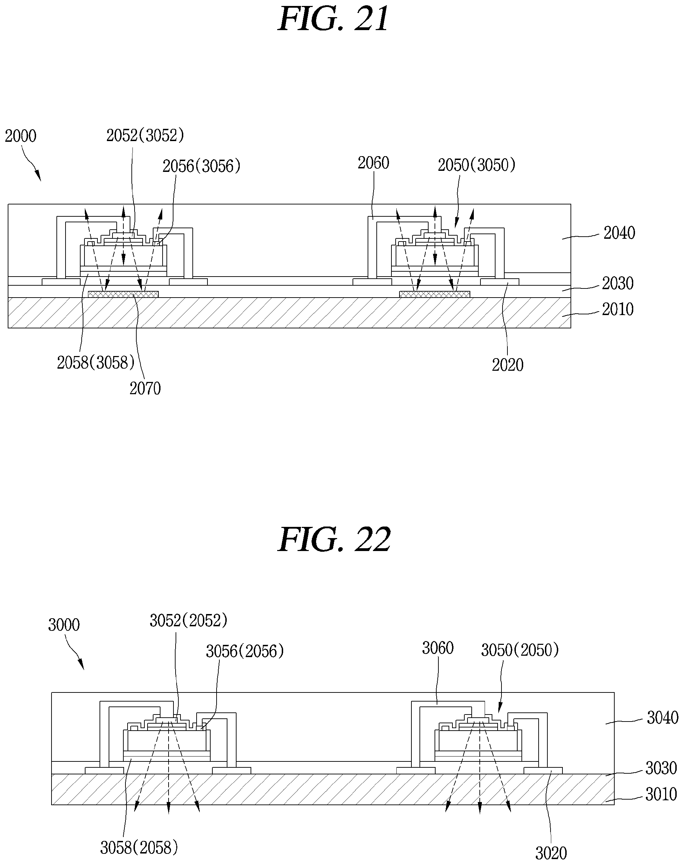

The present disclosure is to solve the problem, and proposes a display device including semiconductor light-emitting devices having a novel structure, capable of being efficiently self-assembled and improving light extraction efficiency. Hereinafter, a structure of a display device according to the present disclosure will be described with reference to FIGS. 21 and 22.

FIG. 21 is a view illustrating one embodiment of a display device according to the present disclosure using the semiconductor light-emitting device according to FIG. 15 or 17, and FIG. 22 is a view illustrating another embodiment of a display device according to the present disclosure using the semiconductor light-emitting device according to FIG. 15 or 17.

According to the present disclosure, the display device 2000, 3000 may include a base 2010, 3010, wiring electrodes 2020, 3020 disposed on the base 2010, 3010, and semiconductor light-emitting devices 2050, 3050. The wiring electrode 2020, 3020 may be electrically connected to the conductive electrodes of the semiconductor light-emitting device, that is, the first conductive electrode 2056, 3056 and the second conductive electrode 2052, 3052. An insulating layer 2030 may be disposed between the wire electrodes 2020, 3020 and the semiconductor light-emitting devices 2050, 3050. On the other hand, the structure illustrated in the drawings is for explaining the present disclosure, and the arrangement of the wiring electrodes, the electrical connection structure between the semiconductor light-emitting devices and the wiring electrodes, and the like in the actual display device may be various implemented depending on an operating method of the display device, the shape of the semiconductor light-emitting device, etc. but may not be limited to any one form. In addition, the display device 2000, 3000 may include a planarization layer 2040, 3040 covering upper surfaces of the semiconductor light-emitting devices 2050, 3050 in the state where the semiconductor light-emitting devices 2050, 3050 are disposed.

Meanwhile, the display device 2000, 3000 according to the present disclosure may include semiconductor light-emitting devices 2050, 3050 having a structure different from that of the related art display device 1000. Specifically, the semiconductor light-emitting device 2050, 3050 may include a first conductive semiconductor layer 2055, 3055 with a first conductive electrode 2056, 3056 formed thereon, an active layer 2054, 3054 disposed on the first conductive semiconductor layer 2055, 3055, a second conductive semiconductor layer 2053, 3053 disposed on the active layer 2054, 3054, and a second conductive electrode 2052, 3052 disposed on the second conductive semiconductor layer 2053, 3053.

Specifically, the first conductive electrode 2056, 3056 and the active layer 2054, 3054 may be disposed on one surface of the first conductive semiconductor layer 2055, 3055, and an undoped semiconductor layer (or buffer layer) 2057, 3057 may be disposed on another surface of the first conductive semiconductor layer 2055, 3055. In addition, a light-transmitting layer 2058, 3058 may be disposed on an opposite side of the first conductive semiconductor layer 2055, 3055 based on the undoped semiconductor layer 2057, 3057. That is, the first conductive semiconductor layer 2055, 3055 may be disposed on one surface of the undoped semiconductor layer 2057, 3057, and the light-transmitting layer 2058, 3058 may be disposed on another surface of the undoped semiconductor layer 2057, 3057. The light-transmitting layer 2058, 3058 may be disposed to improve dielectrophoretic force of the semiconductor light-emitting device 2050, 3050. The light-emitting layer 2058, 3058 may be formed of an electrically conductive material, and disposed on a surface of the semiconductor light-emitting device 2050, 3050 which is seated on an assembly substrate during self-assembly.

In the display device 2000, 3000 according to the present disclosure, the light-transmitting layer 2058, 3058 may be disposed to face the base 2010, 3010, and the light-transmitting layer 2058, 3058 may not be electrically connected to the wiring electrodes 2020, 3020 disposed on the base 2010, 3010.

According to the present disclosure, the light-transmitting layer may be a transparent electrode layer 2058 formed of indium tin oxide (ITO), indium gallium zinc oxide (IGZO), indium zinc oxide (IZO), indium zinc tin oxide (IZTO), or the like, or may be a semiconductor layer (hereinafter, referred to as a semiconductor layer) 3058 doped with an n-type dopant at a high concentration. The semiconductor layer 3058 forming the light-transmitting layer may have electrical conductivity equal to or higher than that of the first conductive semiconductor layer 3055.

According to the present disclosure, the display device may implement a structure in which light is emitted to a top, and a structure in which light is emitted to a bottom. In one embodiment, the display device 2000 may further include a reflective layer 2070 on the base 2010 to implement top emission. The reflective layer 2070 may be formed on the front surface of the base 2010 or at least at a position corresponding to a position where the semiconductor light-emitting device 2050, 3050 is disposed. Accordingly, light passing through the light-transmitting layer 2058, 3058 of the semiconductor light-emitting device 2050, 3050 may be re-reflected toward the front surface by the reflective layer 2070 disposed below the light-transmitting layer 2058, 3058. In this case, the reflective layer 2070 may be formed of Ag, Al, etc. having excellent reflectivity for visible light, and thus minimize light loss. According to this embodiment, the planarization layer 2040 may be formed of a transparent organic film material, and the connection electrode 2060 electrically connecting the conductive electrode and the wiring electrode of the semiconductor light-emitting device may be made of a transparent material, for example, implemented as a transparent electrode. In addition, the second conductive electrode 2052 of the semiconductor light-emitting device may also be configured as a transparent electrode.

As another embodiment, the display device 3000 may implement bottom emission in which light is extracted toward the substrate, and for this purpose, the base 3010 may be made of a light-transmitting material. In addition, the planarization layer 3040 may be coated with a material having high reflectivity, for example, a white insulator or a reflective non-conductive material, and the connection electrode 3060 and the second conductive electrode 3052 of the semiconductor light-emitting device may also be formed of a metal such as Ag or Al having high reflectivity.

According to this embodiment, among light generated by the semiconductor light-emitting device 2050, 3050, light directed toward the rear surface of the substrate may pass through the light-transmitting layer 3058 and the base 3010 so as to be extracted from a substrate side, while light directed to the front surface of the substrate may be reflected from the connection electrode 3060 and/or the planarization layer 3040 to the rear surface side of the substrate.

A display device according to the present disclosure may be a passive matrix (PM) type display device or an active matrix (AM) type display device.

The aforementioned display device may not be limited to the configurations and methods of the previous embodiments, but all or some of the embodiments may be selectively combined such that various modifications can be made.

## Claims

1. A semiconductor light-emitting device comprising:
a first conductive electrode;
a first conductive semiconductor layer having one surface with the first conductive electrode, and another surface with an undoped semiconductor layer;
an active layer disposed on the one surface of the first conductive semiconductor layer;
a second conductive semiconductor layer disposed on the active layer; and
a second conductive electrode disposed on the second conductive semiconductor layer, and
wherein the semiconductor light-emitting device comprises a light-transmitting layer disposed on a surface where the first conductive semiconductor layer is disposed with respect to the undoped semiconductor layer, and formed of a material having electrical conductivity.

2. The semiconductor light-emitting device of claim 1, wherein the light-transmitting layer has at least one surface with surface roughness.

3. The semiconductor light-emitting device of claim 1, wherein the light-transmitting layer is a transparent electrode layer.

4. The semiconductor light-emitting device of claim 3, wherein the light-transmitting layer has a thickness of 30 nm to 500 nm.

5. The semiconductor light-emitting device of claim 1, wherein the light-transmitting layer is a semiconductor layer doped with an n-type dopant.

6. The semiconductor light-emitting device of claim 5, wherein the light-transmitting layer has electrical conductivity that is equal to or higher than that of the first conductive semiconductor layer.

7. The semiconductor light-emitting device of claim 5, wherein the light-transmitting layer has a thickness of 50 nm to 200 nm.

8. A display device comprising:
a base;
semiconductor light-emitting devices disposed on the base and each including conductive electrodes;
wiring electrodes disposed on the base and electrically connected to the conductive electrodes of the semiconductor light-emitting devices;
wherein each of the semiconductor light-emitting devices comprises:
a first conductive electrode;
a first conductive semiconductor layer having one surface with the first conductive electrode, and another surface with an undoped semiconductor layer;
an active layer disposed on the one surface of the first conductive semiconductor layer;
a second conductive semiconductor layer disposed on the active layer; and
a second conductive electrode disposed on the second conductive semiconductor layer, and
wherein the semiconductor light-emitting device comprises a light-transmitting layer disposed on a surface where the first conductive semiconductor layer is disposed with respect to the undoped semiconductor layer, and formed of a material having electrical conductivity.

9. The display device of claim 8, wherein the semiconductor light-emitting device is disposed such that the light-transmitting layer faces the base.

10. The display device of claim 9, wherein the base portion further includes a reflective layer disposed at least at a position corresponding to a position where the semiconductor light-emitting device is disposed.

11. The display device of claim 10, further comprising a connection electrode extending from the first conductive electrode and the second conductive electrode of the semiconductor light-emitting device to the wire electrode,
wherein the connection electrode is made of a transparent material.

12. The display device of claim 9, wherein the base is made of a light-transmitting material.

13. The display device of claim 8, wherein the light-transmitting layer has at least one surface with surface roughness.

14. The display device of claim 8, wherein the light-transmitting layer is a transparent electrode layer.

15. The display device of claim 8, wherein the light-transmitting layer is a semiconductor layer doped with an n-type dopant.
